# EUROPÄISCHE PATENTANMELDUNG

(11) **EP 1 953 826 A1**
(43) Veröffentlichungstag der Anmeldung: **06.08.2008**
(21) Anmeldenummer: 05857395.7
(22) Anmeldetag: 07.11.2005
(51) Int. Cl.: H01L 29/68

(54) **HALBLEITERBAUELEMENT**

(71) Anmelder: Tsoy, Bronya, Moscow, 117342 (RU)
(72) Erfinder: KOGAI, Jury Vasilievich, Riazyanskaya obl., 391480 (RU); TSOI, Valerian Eduardovich, Moskovskaya obl., 142000 (RU); TSOI, Tatyana Sergeevna, Moscow, 117418 (RU)
(74) Vertreter: Kaiser, Magnus
(86) Internationale Anmeldenummer: PCT/RU2005/000547
(87) Internationale Veröffentlichungsnummer: WO 2007/053052

(57) **Zusammenfassung**

Die Erfindung bezieht sich auf Halbleitergeräte. Gemäß einer ersten Ausführungsform weist das Gerät N > 1 Gebiete mit gleichnamiger Leitfähigkeit (p-oder n-Gebiete) (N steht für eine ganze Zahl) und ein Gebiet mit entgegengesetzter Leitfähigkeit unter Bildung von N typengleichen pn-Einzelübergängen auf, wobei die an jedes der N Gebiete mit gleichnamiger Leitfähigkeit anliegenden Elektroden mittels eines Einzelleiters parallel geschaltet sind. Gemäß einer zweiten Ausführungsform enthält das Gerät eine erste Menge mit N1 ≥ 1 Gebieten mit gleichnamiger Leitfähigkeit (p- oder n-Gebieten), eine zweite Menge mit N2 ≥ 1 Gebieten mit derselben Leitfähigkeit und eine dritte Menge mit N3 ≥ 1 Gebieten mit entgegengesetzter Leitfähigkeit unter Bildung eines ersten Satzes aus N1 typengleichen pn-Einzelübergängen und eines zweiten Satzes aus N3 typengleichen pn-Einzelübergängen, wobei N1 + N2 +N3 > 3 ist und die Elektroden, die an die Gebiete aus mindestens einer der angegebenen Mengen, für welche die Bedingung N1 ≥ 2 erfüllt ist, wobei iε {1, 2, 3} ist, anliegen, mittels eines Einzelleiters parallel geschaltet sind. Als Folge hiervon wird einer Streuung begegnet und die Stabilität der elektrischen Werte des Hableitergerätes verbessert, wobei insbesondere die Streuung von Impedanzswerten der pn-Übergänge vermindert wird und außerdem der Impedanzwert selbst in den pn-Übergängen herabgesetzt und die Leistung des Gerätes beachtlich gesteigert wird.

## Beschreibung

### Technisches Gebiet

Die vorliegende Erfindung bezieht sich auf elektronische Halbleitergeräte.

### Bisheriger Stand der Technik

Z. z. bekannte Halbleitergeräte, wie z. B. Dioden, Transistoren, Mikroprozessoren, Fotodetektoren, Solarbatterien, LEDs, Halbleiterlaser od. dgl., werden nach einer herkömmlichen Halbleitertechnologie hergestellt, welcher zufolge im Werkstoff durch Einbringung von Verunreinigungen pn-Übergänge erzeugt werden. Im Regelfall wird (werden) bei sämtlichen Bauarten von Halbleitergeräten ein Einzelübergang (ein Akzeptor- oder Donatorgebiet) oder mehrere gesonderte Einzelübergänge geschaffen, von welchen jeder Übergang je nach der Art des Gerätes (sei es eine Diode oder ein Transistor oder eine Fotodiode oder eine Leuchtdiode od. dgl) seinen konstruktiven Aufbau und seine Funktion besitzt.

Insbesondere werden bei der Fertigung einer Diode in das Halbleiterplättchen Akzeptor- oder Donatorverunreinigungen eingegeben, so dass darin ein pn-Übergang entsteht. An den pn-Übergang liegen zwei gesonderte Einzelelektroden, also eine Anode (positiv) und eine Kathode (negativ), an. Bei Anlegen eines elektrischen Außenfeldes an den pn-Übergang (das Plus an die p-Schicht und das Minus an die n-Schicht, also ein Betrieb mit einer Direktschaltung) bildet sich ein Fluss von zu den betreffenden Elektroden wandernden Ladungsträgern. Bei der Herstellung einer Fotodiode mit der Arbeitsweise einer fotogalvanischen Zelle werden einem Halbleiterplättchen ebenfalls Akzeptor-Donatorverunreinigungen zugesetzt, indem dabei von einer simplen Diode dadurch abgewichen wird, dass auf einen pn-Übergang ein Lichtstrom gerichtet wird, so dass Elektron-Loch-Paare und somit ein Fotostrom erzeugt werden.

Bei der Herstellung eines üblichen Transistors werden zwei gesonderte pn-Einzelübergänge gebildet, die gegeneinander gerichtet sind, also der eine Übergang in direkter Verschiebung und der andere in entgegengesetzter Richtung (Aktivzustand), wie z. B. npn- oder pnp-Übergänge. An diese beiden Übergänge liegen gesonderte Einzelelektroden (Einzelkollektor, Einzelbasis, Einzelemitter oder Einzelsenke, Einzelquelle, Einzelverschluss) an. Bei Anlegen eines elektrischen Außenfeldes an eine als Emitter dienende Basis, also an einen ersten pn-Übergang (im Zustand einer direkten Verschiebung), tritt darin ein einzelner Elektronenfluss von zur Basisschicht wandernden Elektronen auf. Dieser gesonderte Einzelfluss durchsetzt ungehindert die Basisschicht und gelangt an einen Kollektor mit einem positiven Potential (infolge dessen, dass an den pn-Übergang eine umgekehrte Verschiebung angelegt worden ist) und dann weiter an den äußeren Stromkreis einer elektronischen Schaltung.

Der gemeinsame Nachteil bekannter Halbleitergeräte sind ein hoher Wert der Impedanz und deren Srtreuung in pn-Übergängen, die sich aus einer Aktiv- (R), Kapazitäts- (C) und Induktionskomponente (L) zusammensetzt. Dies führt zu einer Senkung des Wirkungsgrades, einer Instabilität der elektrischen Werte, einer bedeutenden Streuung der Stromspannungswerte sowie zu einer Verschlechterung der Empfindlichkeit und Schnellwirkung der Halbleitergeräte. Nachteilig wirkt sich bei den bekannten Halbleitergeräten auch deren Empfindlichkeit gegen Temperatur- und Stromüberlastungen aus.

Daher ist es notwendig, hochpräzise Halbleitergeräte, wie z. B. Dioden, Fotodioden, Leuchtdioden, Transistoren, Mikroschaltungen, Mikroprozessoren od. dgl., bereitzustellen, indem gleichzeitig die Stabilität von Eingangs- und Ausgangswerten verbessert wird, die unter den Bedingungen von elektrischen und thermischen Überlastungen sowie von UHF gebrauchsfähig sind.

Aus dem Stand der Technik ist eine supraleitende Tunneldiode mit zwei, durch eine Halbleiterzwischenlage getrennten Elektroden aus einem Supraleiter bekannt. Um die maximale Betriebsfrequenz und die Leistung zu erhöhen, hat die Halbleiterzwischenlage die Form einer mehrelementigen Heterostruktur, die mindestens aus zwei Halbleiterwerkstoffen mit unterschiedlicher Breite des verbotenen Bandes besteht. Die Lage aus dem schmalbandigen Werkstoff befindet sich zwischen den Lagen der breitbandigen Werkstoffe und bildet eine Potentialmulde für die hauptsächlichen Ladungsträger, die zumindest ein Quantenniveau aufweist (siehe UdSSR-Urheberschein Nr. 1575858, 1988).

Bei dieser Lösung erreicht man eine mindere Streuung von elektrischen Werten (einschl. des Widerstandes), eine bessere Beständigkeit gegen eine mechanische und eine elektrische Überspannung und die Temperatur sowie eine stabile Betriebsweise in einem UHF-Bereich zu Lasten neuer physikalischer Verfahren zur Herstellung von Werkstoffen, welche für den Bau von Halbleitergeräten einsetzbar sind. Hinzu kommt, dass zur Beseitigung der Nachteile von Halbleitergeräten Forscher und Technologen den Weg einer Modifikation auch der chemischen Struktur deren Werkstoffe beschreiten. So bedient man sich insbesondere bei der Herstellung von hochpräzisen Geräten der hochreinen Werkstoffe und Produkte der teueren Nanotechnologie. Dies alles erhöht im Wesentlichen die Kosten für den Bau von Halbleitergeräten und kompliziert immer mehr deren Herstellungsverfahren.

### Offenbarung der Erfindung

Die vorliegende Erfindung setzt sich zum Ziel die Schaffung von hochpräzisen Halbleitergeräten, wie z. B. Dioden, Fotodioden, Leuchtdioden, Transistoren od. dgl., die sich durch eine hohe Stabilität der Eingangs- und Ausgangswerte kennzeichnen, welche unter den Bedingungen von elektrischen und thermischen Überlastungen sowie von UHF funktionsfähig bleiben, indem gleichzeitig auch das Herstellungsverfahren dieser Geräte vereinfacht wird.

Das genannte Ziel wird dadurch erreicht, dass ein Halbleitergerät mit mindestens einem p-Gebiet und mindestens einem n-Gebiet mit an jedes dieser Gebiete anliegenden Elektroden gemäß einer ersten Ausführungsform N > 1 Gebiete mit gleichnamiger Leitfähigkeit (N steht dabei für eine ganze Zahl) und ein Gebiet mit entgegengesetzter Leitfähigkeit unter Bildung von N einzelnen typengleichen pn-Übergänge aufweist, wobei die an jedes der N Gebiete mit gleichnamiger Leitfähigkeit anliegenden Elektroden mit Hilfe eines Einzelleiters parallel geschaltet, d. h. zu einer Einheit zusammengefasst sind.

In einer Weiterbildung der Ausführungsform können die genannten N Gebiete mit gleichnamiger Leitfähigkeit p-Gebiete sein, indem das angegebene Einzelgebiet mit entgegengesetzter Leitfähigkeit ein n-Gebiet ist.

Dabei können an das angegebene n-Einzelgebiet M Elektroden anliegen, wobei 1 ≤ M ≤ N ist und an das angegebene n-Gebiet eine Elektrode (M = 1) oder mehrere Elektroden (M > 1) anliegen können. In dem letzteren Fall sind die ans n-Gebiet anliegenden Elektroden mittels eines Einzelleiters vorzugsweise parallel geschaltet, also zu einer Einheit zusammengefasst. Wenn M = N ist, befinden sich bevorzugt die an das n-Einzelgebiet anliegenden Elektroden im Wesentlichen gegenüber jedem der p-Gebiete.

Gemäß einer anderen Weiterbildung können N Gebiete mit gleichnamiger Leitfähigkeit n-Gebiete sein, indem das angegebene Einzelgebiet mit entgegengesetzter Leitfähigkeit ein p-Gebiet ist.

Dabei können in ähnlicher Weise an das angegebene p-Einzelgebiet M Elektroden bei 1 ≤ M ≤ N anliegen, wobei an das angegebene p-Gebiet eine Elektrode (M = 1) oder mehrere Elektroden (M > 1) anliegen kann bzw. können. In dem letzteren Fall sind die an das p-Gebiet anliegenden Elektroden vorzugsweise mittels eines Einzelleiters parallel geschaltet, d. h. zu einer Einheit zusammengefasst. Wenn M = N ist, befinden sich bevorzugt die an das p-Einzelgebiet anliegenden Elektroden im Wesentlichen gegenüber jedem der n-Gebiete.

Bei verschiedenen Weiterbildungen der Ausführungsform der Erfindung kann die Anzahl von pn-Übergängen gleich 4 oder 8 bzw. 16 oder 200 oder darüber ausgewählt werden.

Das genannte Ziel wird auch dadurch erreicht, dass ein Halbleitergerät mit mindestens einem p-Einzelgebiet und mindestens einem n-Einzelgebiet mit an jedes der besagten Gebiete anliegenden Elektroden gemäß einer zweiten Ausführungsform eine erste Menge mit N1 ≥ 1 Gebieten mit gleichnamiger Leitfähigkeit, eine zweite Menge mit N2 ≥ 1 Gebieten mit derselben Leitfähigkeit und eine dritte Menge mit N3 ≥ 1 Gebieten mit entgegengesetzter Leitfähigkeit aufweist, indem ein erster Satz aus N1 typengleichen pn-Einzelübergängen und ein zweiter Satz aus N3 typengleichen pn-Einzelübergängen gebildet werden, wobei N1 + N2 + N3 > 3 ist und die an die Gebiete aus mindestens einer der genannten Mengen anliegenden Elektroden, für welche die Bedingung N1 ≥ 2 bei i gleich 1 oder 2 oder 3 erfüllt ist, mittels eines Einzelleiters parallel geschaltet, d. h. zu einer Einheit zusammengefasst sind.

Bei einer Weiterbildung können die angegebenen Gebiete mit gleichnamiger Leitfähigkeit aus der ersten und zweiten Menge p-Gebiete sein, wobei die dritte Menge ein oder mehrere n-Gebiete aufweist. Dabei kann die erste und/oder zweite Menge mehr als ein p-Gebiet enthalten, wobei die an jedes der angegebenen p-Gebiete aus der ersten und/oder zweiten Menge anliegenden Elektroden vorzugsweise mittels eines Einzelleiters parallel geschaltet, d. h. zu einer Einheit zusammengefasst sind. Darüber hinaus vermag die dritte Menge mehr als ein n-Gebiet aufzuweisen, wobei die an jedes der angegebenen n-Gebiete aus der dritten Menge anliegenden Elektroden vorzugsweise ebenfalls mittels eines Einzelleiters parallel geschaltet, d. h. zu einer Einheit zusammengefasst sind. In Weiterbildungen können die erste, zweite und dritte Menge eine gleiche Anzahl von p- und n-Gebieten, also (N1 = N2 = N3), enthalten oder die erste und zweite Menge können eine gleiche Anzahl von p-Gebieten (N1 = N2) enthalten oder die erste und dritte Menge können eine gleiche Anzahl von p- und n-Gebieten, also (N1= N3), enthalten oder die zweite und dritte Menge können eine gleiche Anzahl von p- und n-Gebieten, also (N2 = N3), enthalten.

Gemäß einer anderen Weiterbildung können die genannten Gebiete mit gleichnamiger Leitfähigkeit aus der ersten und zweiten Menge n-Gebiete sein, wobei dann die dritte Menge ein oder mehrere p-Gebiete enthält. Dabei können die erste und/oder zweite Menge mehr als ein n-Gebiet aufweisen, wobei die an jedes der genannten n-Gebiete aus der ersten und/oder zweiten Menge anliegenden Elektroden bevorzugt mittels eines Einzelleiters parallel geschaltet, d. h. zu einer Einheit zusammengefasst sind. Darüber hinaus kann die drtte Menge mehr als ein p-Gebiet enthalten, wobei die an jedes der genannten p-Gebiete aus der dritten Menge anliegenden Elektroden bevorzugt ebenfallsmittels eines Einzelleiters parallel geschaltet, d. h. zu einer Einheit zusammengefasst sind. Gemäß Weiterbildungen können die erste, zweite und dritte Menge eine gleiche Anzahl von n- und p-Gebieten, also (N1 = N2 = N3), enthalten oder die erste und zweite Menge können eine gleiche Anzahl von n-Gebieten (N1 = N2) enthalten oder die erste und dritte Menge können eine gleiche Anzahl von n- und p-Gebieten, also (N1 = N3), enthalten oder die zweite und dritte Menge können eine gleiche Anzahl von n- und p-Gebieten, also (N2 = N3), enthalten.

Wie nachfolgend erläutert wird, wird dank einer solchen Ausgestaltung eines Halbleitergerätes eine Streuung vermieden und eine bessere Stabilität dessen elektrischer Werte sichergestellt, wobei insbesondere die Streuung der Impedanzwerte von pn-Übergängen gesenkt und außerdem der Impedanzwert selbst bei pn-Übergängen verringert und somit die Leistung des Gerätes im Wesentlichen erhöht wird. Dabei sind bei der Herstellung von Halbleitergeräten handelsübliche Werkstoffe mit herkömmlichem Reinheitsgrad, beispielsweise z. Z. weitgehend verwendbares kommerzielles Silizium, sowie ein übliches Herstellungsverfahren zur Herstellung von Halbleitergeräten, wie eine Epitaxie oder eine Diffusionsbeschichtung mit einer Fotolithografie, anwendbar. Dadurch kann der Investaufwand bei der Entwicklung neuer Halbleitergeräte beachtlich herabgesetzt werden.

Im Rahmen der vorliegenden Erfindung werden unter typengleichen pn-Übergängen solche Übergänge verstanden, die mit Hilfe von ein und demselben Verfahren (unter gleichen Bedingungen) aus ein und denselben Werkstoffen (bei Anwendung von ein und denselben Verunreinigungen in gleichen Mengen) hergestellt werden, welche im Wesentlichen eine gleiche Geometrie und Form sowie im Wesentlichen gleiche struktur-empfindliche physikalische (mechanische, elektrische, elektromagnetische u. a.) Kennwerte und Eigenschaften aufweisen. Der Fall, bei dem sämtliche pn-Übergänge absolut identisch sind, gilt als bevorzugt, ist jedoch in der Praxis schwer realisierbar. Darüber hinaus wird unter einer Absonderung von pn-Übergängen das Fehlen deren sich schneidender und/oder übereinstimmender Bereiche verstanden, d. h. dass jeder der pn-Übergänge von anderen pn-Übergängen im Gerät abgesondert (getrennt) angeordnet ist.

### Kurze Beschreibung der Zeichnungen

Die Erfindung wird nachstehend mit Hilfe deren konkreter Ausführungsbeispiele unter Bezugnahme auf die beigefügten Zeichnungen näher erläutert. Dabei zeigen :
Fig. 1 ein Schema einer erfindungsgemäßen UHF-Diode;
Fig. 2 ein Schema eines erfindungsgemäßen fotogalvanischen Elementes aus einem Kristallsilizium;
Fig 3 ein Schema eines fotogalvanischen Elementes aus einem amorphen Silizium, eine Seitenansicht (im Schnitt):
Fig. 4 dito wie in Fig. 3, eine Draufsicht;
Fig. 5 ein Strukturschema für einen erfindungsgemäßen bipolaren Transistor;
Fig. 6 ein Schema des konstruktiven Aufbaues eines erfindungsgemäßen bipolaren Transistors;
Fig. 7 ein vergleichendes Variationsdiagramm für die Verteilung von Widerstandswerten der pn-Übergänge in UHF-Dioden je nach der Anzahl der pn-Übergänge N;
Fig. 8 ein vergleichendes Variationsdiagramm für die Verteilung von Widerstandswerten der pn-Übergänge im statischen Zustand bei einer Kontroll-Fotovoltaikzelle und für die Verteilung von Widerstandswerten der pn-Übergänge in einer Fotovoltaikzelle gemäß der Erfindung;
Fig. 9 ein Vergleichsdiagramm für die Abhängigkeit des Fotostromes Ifge einer Kontroll-Fotovoltaikzelle mit einem pn-Einzelübergang und einer erfindungsgemäßen Fotovoltaikzelle;
Fig. 10 ein vergleichendes Variationsdiagramm für die Verteilung der Ausgangsstromwerte eines Kollektors für handelsübliche und erfindungsgemäße Transistoren;
Fig. 11 ein Vergleichsdiagramm für statische Ausgangs-Voltamperecharakteristiken eines kommerziellen Kontrolltransistors (KT-315 G) und eines erfindungsgemäßen Transistors.

### Beste Ausführungsformen der Erfindung

Halbleitergeräte gemäß einer ersten Ausführungsform umfassen Dioden, insbesondere eigentliche Dioden (darunter auch UHF-Dioden), Fotodioden, Leuchtdioden, Halbleiterlaser od. dgl.

### Beispiel 1 : UHF-Diode

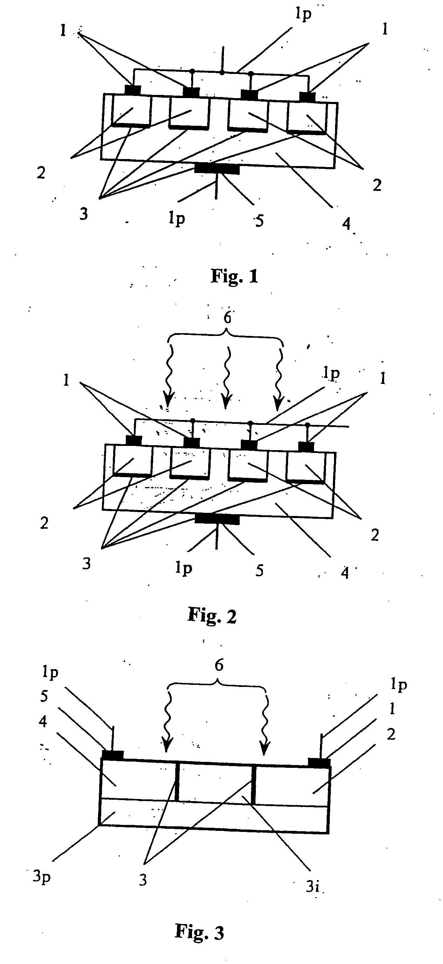

Das Strukturschema für eine UHF-Diode, die gemäß der ersten Ausführungsform der vorliegenden Erfindung ausgestaltet ist, ist in Fig. 1 gezeigt. Die UHF-Diode umfasst vier (N = 4) p-Gebiete 2 und ein n-Gebiet 4 unter Bildung von vier typengleichen pn-Einfzelübergängen 3, wobei die an die genannten p-Gebiete 2 anliegenden Elektroden 1 mittels eines Stromkreises (Elementes) 1p parallel geschaltet sind, indem an das n-Einzelgebiet 4 nur eine Elektrode 5 anliegt. Es sei angemerkt, dass die Anzahl der ans n-Gebiet anliegenden Elektroden 5 variieren kann und mehr als 1, aber nicht größer als die Anzahl der p-Gebiete 2 (und jeweils der pn-Übergänge 3) sein kann. Bei gleicher Anzahl der Elektroden 5 und der Elektroden 1 werden die Elektroden 5 vorzugsweise im Wesentlichen gegenüber der betreffenden p-Gebiete 4 angeordnet, um den summarischen Widerstand des Gerätes minimieren zu können. Hinzu kommt, dass bei Vorhandensein von mehreren Elektroden 5 diese ebenfalls mittels eines Einzelleiters parallel geschaltet, d. h. zu einer Einheit zusammengefasst werden sollen.

Gemäß der ersten Ausführungsform der Erfindung bei Anwendung einer standardisierten Technologie, welche eine Diffusionsbeschichtung, eine Fotolithografie, eine Endmontage und ein Schneiden von Mikrochips mit darauf angeordneten Diodenbestandteilen beinhaltet, wurde eine UHF-Si-Diode hergestellt, die auf einem Kontakt "Halbleiter/Metall" (ein Schottky-Übergang) basiert. Dazu bediente man sich eines handelsüblichen Si-Substrats mit einer Dicke von 72 µm und einem Durchmesser von 150 mm. Auf eine obere Ebene des Substrats wurden unter Zuhilfenahme von Fotomasken mit vier Fenstern Verunreinigungen aufgebracht, in deren Eigenschaft Bor eingesetzt wurde. Somit hat man in einer Diodenzelle als Chip je 4 pn-Übergänge erzeugt. Die Chipmaße betrugen 450 x 450 µm. Dann wurden von oben und auf eine untere Ebene des Si-Substrates stromleitende Elemente 1p und als Kontakte dienende Elektroden 1 und 5 aus einem Golddraht und einer -folie aufgetragen. Die Fläche der unteren Elektrode 5 war gleich der Summe der Flächen der oberen Fenster (d. h. der Fläche der Fenster von 4 pn-Übergängen). Auf dem vorliegenden Substrat fanden 100 Diodenzellen Platz.

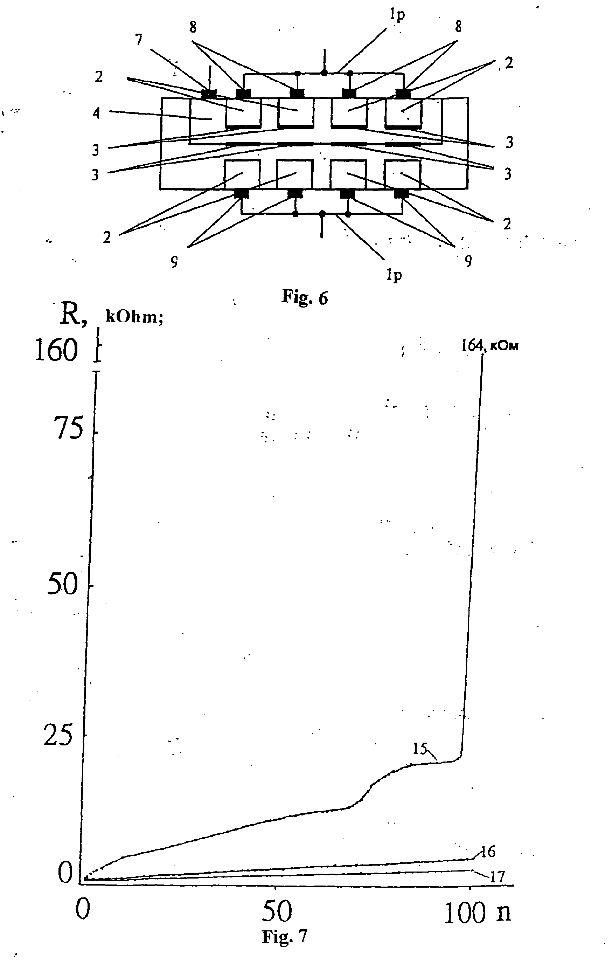

Nachweise für die Erreichung eines technischen Ergebnisses bei einer auf diese Art und Weise hergestellten Diode sind in Fig. 7 und der Tabelle 1 geliefert. Zum Vergleich sind in Fig. 7 die Impedanzwerte im statischen Zustand einer serienmäßigen UHF-Kontrolldiode (Kurve 15) und einer erfindungsgemäßen UHF-Diode (Kurven 16 und 17) aufgeführt. Wie aus Fig. 7 erkennbar ist, liegt bei der serienmäßigen UHF-Diode die Widerstandsstreuung zwischen 0,6 kOhm und 164 kOhm. Unterdessen ist bei der erfindungsgemäßen UHF-Diode die Streuung der Impedanzwerte praktisch vermieden, wobei gleichzeitig der Impedanzwert selbst vermindert wird. Demgemäß wird bei der erfindungsgemäßen Diode nicht nur einer Streuung von Widerstandswerten begegnet, was stabile Voltamperecharakteristiken ergibt, sondern auch gleichzeitig der Widerstandswert herabgesetzt, so dass sich der Strom und die Leistung der erfindungsgemäßen Diode erhöhen.

Wie aus der Tabelle 1 ersichtlich ist, ist bei der erfindungsgemäßen UHF-Si-Diode bei einer Frequenz von 1 GHz keine Streuung des Widerstandes und der Kapazität zu verzeichnen. Währenddessen sind diese Charakteristiken bei der serienmäßigen kommerziellen Diode durch eine nennenswerte Streuung gekennzeichnet. Der Widerstand der pn-Übergänge in erfindungsgemäßen Dioden wurde vier mal so gering, die Kapazität blieb auf dem gleichen Niveau erhalten und die Durchschlagsspannung hat sich um das 2fache erhöht. Um die Kapazität zu erniedrigen, soll die Fläche der unteren Elektrode 5 vermindert werden. Bei Versuchsmustern hat man auf diese Weise eine 1,5 so geringe Kapazität erreicht.

**Tabelle 1**

| Elektrische Werte von Si-Dioden mit vier pn-Übergängen bei einer Frequenz von 1 GHz, welche unter industriellen Bedingungen entsprechend der vorliegenden Erfindung (1 bis 7) hergestellt waren, und serienmäßige kommerzielle (8 bis 14) einelementige (N =1) Kontroll-Si-Dioden | | | |
|---|---|---|---|
| Lfd. Nr. | Diodenkapazität, pF (U = 0, f = 1 GHz). Zahl von pn-Übergängen N = 4 | Durchschlagsspannung, V (Rückstrom, I = 10 µA) | Verlustwiderstand, Ohm (Vorwärtsstrom, I = 30mA, f = 1 GHz) |
| Erfindungsgemäße Versuchs-Siliziumdioden mit vier pn-Übergängen | | | |
| 1 | 0,2 | 32 | 0,6 |
| 2 | 0,2 | 32 | 0,6 |
| 3 | 0,2 | 32 | 0,6 |
| 4 | 0,2 | 32 | 0,6 |
| 5 | 0,2 | 32 | 0,6 |
| 6 | 0,2 | 32 | 0,6 |
| 7 | 0,2 | 32 | 0,6 |

| | Diodenkapazität, pF (U = 0, f = 1 GHz). Zahl von pn-Übergängen N = 1 | Durchschlagsspannung, V (Rückstrom, I = 10 µA) | Verlustwiderstand, Ohm (Vorwärtsstrom, I = 30mA, f = 1 GHz) |
|---|---|---|---|
| Kommerzielle Kontroll-Siliziumdioden mit einem pn-Einzelübergang | | | |
| 8 | 0,215 | 16 | 2,5 |
| 9 | 0,208 | 16 | 2,3 |
| 10 | 0,221 | 16 | 2,4 |
| 11 | 0,214 | 16 | 2,1 |
| 12 | 0,206 | 16 | 2,2 |
| 13 | 0,207 | 16 | 2,9 |
| 14 | 0,200 | 16 | 2,1 |

### Beispiel 2 : Fotodiode mit der Arbeitsweise eines fotogalvanischen Elementes (einer Fotovoltaikzelle)

### Ausführungsform A.

Ein Schema für den konstruktiven Aufbau eines fotogalvanischen Elementes (einer Fotovoltaikzelle), hergestellt aus einem Kristallsilizium gemäss der ersten Ausführungsform dieser Erfindung, ist in Fig. 2 gezeigt. Das fotogalvanische Element weist vier p-Gebiete 2 und ein n-Gebiet 4 auf, die gemeinschaftlich vier typengleiche pn-Einzelübergänge 3 bilden. Dabei sind die an die n-Gebiete anliegenden Elektroden (Anoden) 1, genauso wie im vorherigen Beispiel, mittels eines Einzelleiters (eines stromleitenden Elementes) 1p parallel geschaltet, d. h. zu einer Einheit zusammengefasst, während an das n-Gebiet eine negative Einzelelektrode (Kathode) anliegt. Ein Lichtstrom 6 wird bei diesem Beispiel dem pn-Übergang 3 über die Elektrode 1 und das p-Gebiet (die p-Gebiete) 2 zugeführt.

Für die Herstellung einer Fotovoltaikzelle sind im Wesentlichen beliebige Halbleiterwerkstoffe geeignet. Gegenwärtig hat sich eine Technologie bei Anwendung eines Kristallsiliziums weitestgehend durchgesetzt, deren Wirkungsgrad sich auf 15 % beläuft. Am billigsten ist ein Herstellungsverfahren zur Herstellung einer Fotovoltaikzelle aus einem amorphen Silizium (siehe weiter unten eine Ausführungsform B), welches es gestattet, einen Lichtstrom unmittelbar auf den pn-Übergang zu richten. Jedoch zur Zeit kann der Wirkungsgrad des amorphen Siliziums praktisch nur noch ca. 12 % erreichen. Die vorgeschlagene Erfindung trägt wesentlich dazu bei, den Wirkungsgrad der Zellen aus amorphem und Kristallsilizium zu steigern.

### Ausführungsform B.

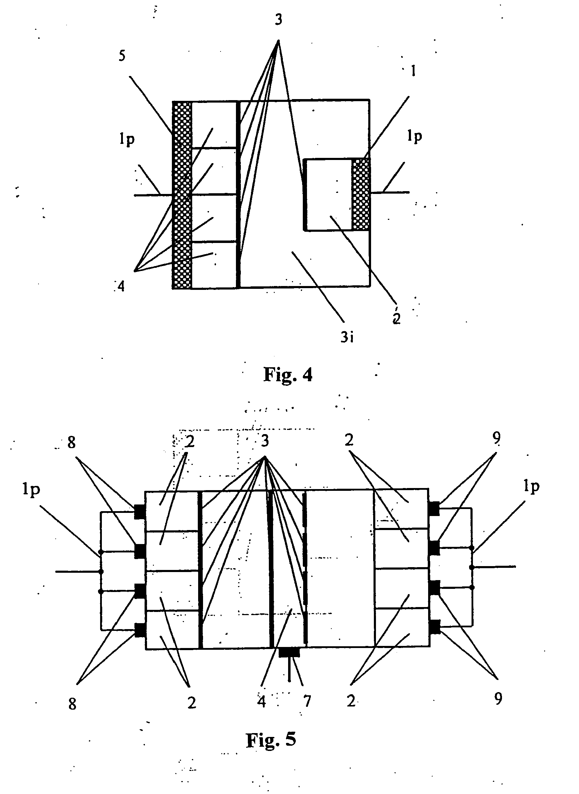

Die Struktur und das Schema des konstruktiven Aufbaues einer bündelförmigen Fotovoltaikzelle aus amorphem Silizium sind in Figuren 3 und 4 veranschaulicht. Die auf der Verwendung des amorphen Siliziums basierende Technologie gilt z. Z. als die billigste und gestattet es, einen Lichtstrom direkt einem pn-Übergang zuzuführen. Sie weicht nicht von der Herstellungstechnologie eines fotogalvanischen Elementes aus dem Kristallsilizium ab. Bei der Fertigung einer Fotovoltaikzelle bedient man sich eines Substrates 3p (Fig. 3) beispielsweise aus Quartzglas, auf welches eine 0,5 bis 1 µm dicke Schicht aus amorphem Silizium, also eine sogenannte i-Schicht, aufgetragen wird. Danach werden an der Oberfläche des amorphen Siliziums p- und n-Schichten geformt. Zu diesem Zweck werden in die i-Schicht beispielsweise im linken und rechten Teil der Zelle die betreffenden Verunreinigungen, also Phosphor und Bor, eingebracht. Als Folge hiervon bleiben zwischen den n- und p-Schichten ein Band und eine Schicht aus unlegiertem amorphem Silizium (in Fig. 3 und 4 als 3i eingezeichnet), in welcher ein pn-Übergang 3 erzeugt wird. Die Schicht 3i benötigt man, um die Ladungsträger bei der Einwirkung des elektrischen Feldes des pn-Überganges besser trennen zu können. Für eine erfindungsgemäße Fotovoltaikzelle werden mehrere pn-Übergänge geschaffen. Wie die Fig. 4 zeigt, kann die Fotovoltaikzelle vier p-Gebiete 4, welche getrennt voneinander erzeugt sind, und ein n-Gebiet 2 aufweisen, so dass vier pn-Übergänge 3 gebildet werden. Dabei sind die ans p-Gebiet anliegenden positiven Elektroden 5 mittels eines Einzelleiters 1p parallel geschaltet, wobei die ans n-Gebiet anliegende negative Elektrode 1 eine Kontaktfläche besitzt, die vier mal so klein ist wie die summarische Kontaktfläche der Elektroden 5. Dank der Ausgestaltung der Fotovoltaikzelle aus amorphem Silizium erhöht sich das Absorptionsvermögen eines pin-Überganges um das 20fache gegenüber einer Ausgestaltung aus Kristallsilizium.

Bei der Fertigung einer Fotovoltaikzelle bediente man sich einer standardisierten Halbleitertechnologie und der Fotolithografie. Dazu benutzte man ein handelsübliches Si-Substrat mit einer Dicke von 300 µm und einem Durchmesser von 100 mm. Auf dem oberen Teil des Substrats werden mit Hilfe von Fotomasken mit 4 Fenstern, deren Größe mit der Fläche der pn-Übergänge übereinstimmt, Verunreinigungen durch ein Diffusionsverfahren (oder durch ein anderes Verfahren) eingebracht und somit pn-Übergänge geschaffen. Dann wurde auf der oberen und unteren Substratfläche mittels der Fotolithografie die gesamte Verdrahtung, wie Strompfäde und Kontaktflächen für die Elektroden sowie Anschlüsse für die äußeren Schaltungen hergestellt. Auf diese Art und Weise kann auf nur einem Substrat eine ziemlich hohe Anzahl von elementaren fotogalvanischen Zellen untergebracht werden.

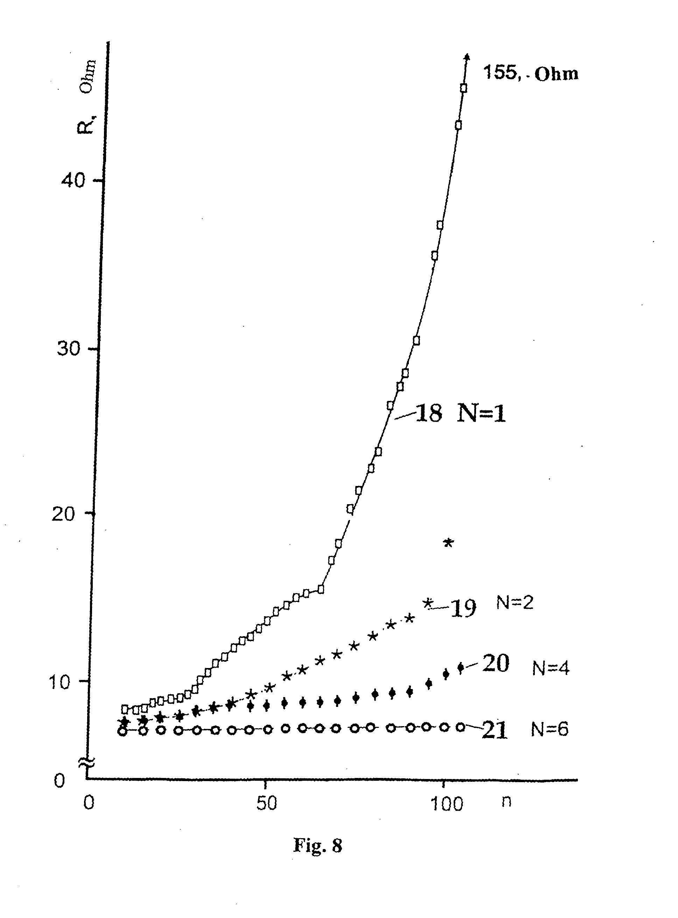

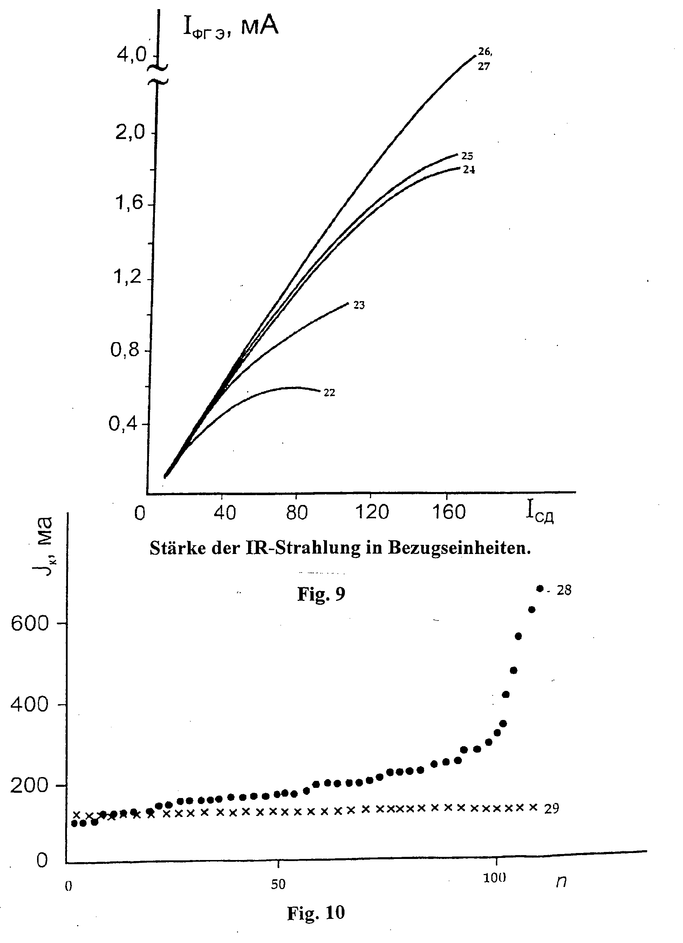

Nachweise für die Erreichung eines technischen Ergebnisses durch die derart hergestellten fotogalvanischen Zellen sind in Figuren 8, 9 und in Tab. 2 angeführt. Zur Gegenüberstellung benutzte man Kontroll-Fotovoltaikzellen mit äquivalenter fotoempfindlicher Fläche, d. h. dass auf die Kontroll-Fotozellen und auf die erfindungsgemäßen Fotozellen ein Lichtstrom gleicher Intensität gerichtet wurde. Dazu wurde bei den erfindungsgemäßen Fotovoltaikzellen Fenster zur Beleuchtung geplant, deren Größe gleich derselben der Kontrollzellen ist. Die Fensterfläche belief sich auf 9 mm2. Zur Beleuchtung der fotoempfindlichen Flächen benutzte man eine Leuchtdiode AL 107B als geeichte IR-Strahlungsquelle.

Fig. 8 zeigt eine Verteilung von Widerstandswerten R eines pn-Überganges bei kommerziellen Kontrollmustern einer Fotovoltaikzelle mit einem Einzelübergang (Kurve 18, N = 1) und bei Fotovoltaikzellen gemäß der ersten Ausführungsform der Erfindung (Kurven 19 bis 21) mit einer Anzahl der Übergänge N = 2, 4, 6. Die Angaben sind in Form von Diagrammen für die Verteilung von Widerstandswerten in zunehmender Folge der Nummer n aufgeführt. Man hat je 100 Muster getestet. Daraus ist es ersichtlich, dass die kommerziellen Kontrollmuster eine bedeutende Streuung in Bezug auf den Widerstandswert aufweisen, während die erfindungsgemäßen Muster bei N = 4 oder N = 6 stabil bleiben und nahezu keine Streuung bezüglich der Größe haben.

Die Erreichung eines technischen Ergebnisses wird auch durch die in Fig. 9 und der Tabelle 2 zusammengefassten Angaben nachgewiesen. Wie aus Fig. 9 gut ersichtlich ist, sind die Fotoströme der Kontrollmuster instabil und weisen eine beträchtliche Streuung bezüglich der Größe (Kurven 22 bis 25) auf. Bei den erfindungsgemäßen Fotovoltaikzellen wird der Fotostrom mit der Vergrößerung der Zahl von pn-Übergängen N stabiler (Kurven 26, 27) und hat einen beachtlich höheren Wert. In zahlenmäßigem Ausdruck wachsen der Fotostrom und die Spannung (innerhalb der Zahl der Schichten als Elemente von N = 4) um das 5- bis 10fache an, wobei sich der Fotostrom mit weiterer Zunahme der Zahl N um einen größeren Wert erhöht. Die gewonnenen Ergebnisse und die Berechnungen für die Kontroll- und die erfindungsgemäßen Fotovoltaikzellen sind in Tab. 2 zusammengestellt.

**Tabelle 2**

| Vergleich der technischen Daten einer Kontroll-Fotovoltaikzelle und einer erfindungsgemäßen Zelle Vergleich der fotogalvanischen Zellen | |
|---|---|
| Kontrollzelle | Erfindungsgemäße Zelle |
| Foto-EMK : 0,5 V; | Foto-EMK : 0,5 V; |
| Kurzschlußstrom : 25 mA; | Kurzschlußstrom : 100 mA; |
| Leistung im Leerlaufbetrieb : 0,013 W; | Leistung im Leerlaufbetrieb : 0,05 W; |
| Streuung von Widerstandswerten eines pn-Überganges in dynamischem Zustand: 5 bis 20 Ohm | Streuung von Widerstandswerten eines pn-Überganges in dynamischem Zustand: 0 (5 bis 5 Ohm) |

| Vergleich der theoretischen Kennwerte eines Solarmoduls auf Grundlage einer üblichen Si-Zelle und einer erfindungsgemäßen Fotovoltaikzelle | |
|---|---|
| Solarmodul aus handelsüblichen Si-Fotozellen: | Solarmodul aus erfindungsgemäßen Fotozellen: |
| Nennleistung : 10 W; | Nennleistung : 10 W; |
| Leerlaufspannung : 0,5 V; | Leerlaufspannung : 0,5 V; |
| Kurzschlußstrom : 25 mA; | Kurzschlußstrom : 100 mA; |
| Fotoempfindliche Fläche in Bezugseinheiten : 1; | Fotoempfindliche Fläche in Bezugseinheiten : 0,25; |
| Modulmasse in Bezugseinheiten : 1; | Modulmasse in Bezugseinheiten : 0,25; |
| Selbstkosten in Bezugseinheiten : 1; | Selbstkosten: 0,25; |
| Lebensdauer: 1 | Lebensdauer: 10 |

Aus dem Vergleich dieser Angaben lässt es sich abschließen, dass die erfindungsgemäße Fotovoltaikzelle mit einer Zahl der pn-Übergänge von N = 4 an den technischen Daten der üblichen Si-Fotovoltaikzelle bedeutend überlegen ist. Bei Vergrößerung der Zahl der Übergänge über 4 verstärkt sich der Effekt um eine noch höhere Größe. So erhöhen sich z. B. der Fotostrom und die Leistung der Fotovoltaikzelle bei N = 8 um das 8fache.

Auf Grund der vorstehend beschriebenen Beispiele sollen die wichtigsten Abweichungen der üblichen Dioden, deren Wirkungsweise auf Effekten in pn-Übergängen (Foto-, Leuchtdioden, Halbleiterlaser od. dgl.) beruht, von den Halbleitergeräten gemäß der ersten Ausführungsform der beanspruchten Erfindung im besonderen hervorgehoben werden. Alle modernen (herkömmlichen) Dioden sind ein Einzelhalbleitergerät, also ein Umformer. Wenn dies eine Fotodiode ist, wandelt sie eine außen angelegte Spannung in Form einer Lichtenergie in eine elektrische Energie eines Gleichstromes um, und wenn das einfach eine Diode ist, wird das außen angelegte Wechselfeld in solchem Gerät zu einem Gleichstrom umgewandelt, d. h. das Halbleitergerät ist ein Wechselstrom-Gleichrichter. Und umgekehrt, wenn beispielsweise eine Diode von einem äußeren elektrischen Gleichfeld beaufschlagt wird, wird dann das elektrische Gleichfeld zu einem Wechselfeld (ein generatorischer Betrieb) usw. umgewandelt. Bei Halbleitergeräten mit der Betriebsweise einer Diode, wie das den eingangs beschriebenen Beispielen zu entnehmen ist, vollzieht sich außerdem eine Stromverstärkung, d. h. bei den Halbleitergeräten gemäß der ersten Ausführungsform der Erfindung handelt es sich um eine Vorrichtung, die aus zwei Geräten, also einem Umformer und einem Verstärker, besteht. Demzufolge zeigt sich die grundsätzliche und wesentliche Abweichung der Halbleitergeräte mit zwei Sätzen von p- und n-Gebieten (der Dioden) gemäß der ersten Ausführungsform der Erfindung von den aus dem Stand der Technik bekannten Analogielösungen darin, dass die Struktur gleichzeitig einen Stromrichter und einen -verstärker umfasst. Eine Stromverstärkung geschieht dank einer Verringerung des inneren Scheinwiderstandes der pn-Übergänge im Parallelkreis der Innenstruktur der Diode. Bei den geschaffenen Diodenstrukturen ist bei einer Vergrößerung der Zahl N > 1 von pn-Übergängen in einem Einzelparallelkreis die Streuung der Werte des inneren Scheinwiderstandes dieses Parallelkreises (der Schaltung) restlos beseitigt, während der Impedanzwert eines solchen summarischen pn-Überganges stabil wird und einen Mindestwert anstrebt. Als Folge davon tritt in der Struktur eines Halbleiters ein Bereich mit niedrigerem Widerstand auf und entsteht darin ein zusätzliches leistungsstarkes elektrisches Feld, in welchem sich eben der Strom verstärkt. Das ist in Fig. 8 deutlich erkennbar, in welcher die Messwerte der Widerstände der pn-Übergänge von 4 Diodenserien (Kontroll- und erfindungsgemäße Dioden) zum Ausdruck kommen.

Eine zweite Ausführungsform der Erfindung bezieht sich auf Transistoren, einschl. der bipolaren und Feldtransistoren.

### Beispiel 3: Bipolarer Transistor

Das Strukturschema und der konstruktive Aufbau eines erfindungsgemäßen bipolaren Transistors sind in Figuren 5 und 6 dargestellt. Bei solch einem Transistor sind zwei Gruppen von pn-Übergängen zu verzeichnen, deren Entstehung aus dem Vorhandensein zweier Mengen der p-Gebieten 2 und einer Menge der n-Gebiete 4 im Halbleitergerät herrührt, wobei die letztere ein n-Gebiet 4 und mehr umfassen kann. Die Figuren 5 und 6 zeigen, dass die erste und zweite Menge je vier p-Gebiete 2 haben und die dritte Menge ein n-Gebiet 4 hat. Als Folge davon bestehen zwei Sätze von pn-Übergängen mit vier pn-Übergängen pro jeden Satz. Die an die Gebiete zumindest einer der Mengen mit zwei und mehr Gebieten anliegenden Elektroden sind mittels eines Leiters parallel geschaltet. Insbesondere sind die Elektroden 8 (eines Emitters) und 9 (eines Kollektors), welche an die p-Gebiete 2 jeweils aus der ersten und zweiten Menge anliegen, mit Hilfe von Einzelleitern 1p parallel geschaltet, wobei an das n-Gebiet 4 (die Basis) eine Einzelelektrode 7 anliegt.

Für die Herstellung des angegebenen Transistors bedient man sich einer genormten Technologie. Dabei verwendet man z. B. eine handelsübliche 100 mm lange und 270 µm dicke Substratplatte aus einem Halbleiterstoff, beispielsweise einem p-Silizium, mit polierter Oberfläche. Dann werden sämtliche Schritte zur Unterbringung von pn-Übergängen, Strompfäden, Elektroden und Anschlüssen auf dieser Oberfläche mittels der Fotolithografie vorgenommen. Auf einem handelsüblichen Si-Substrat kommt normalerweise eine ziemlich hohe Anzahl von Elementarzellen angeordnet, auf denen sich im Grunde genommen ein Transistor befindet. Der verfahrenstechnische Zyklus von sukzessiven Verfahrensschritten ist an und für sich allgemein bekannt. Bei der Realisierung der Erfindung gemäß der zweiten Ausführungsform ändert sich in der Halbleitertechnologie nur noch die Zahl der Fenster und deren Form in Anpassung an die pn-Übergänge, die Strompfäde und die Elektroden. Um einen Transistor der erfindungsgemäßen Bauart herstellen zu können, soll die Fensterzahl für die pn-Übergänge z. B. um das 4fache erhöht werden (d. h. die Zahl von Übergängen N ist gleich 4). In konstruktiver Hinsicht ist bei einer Fotomaske ein Stromkreis vorgesehen, durch welchen vier Fenster für die pn-Übergänge parallel geschaltet sind. Somit handelt es sich bei der Herstellung eines erfindungsgemäßen bipolaren Transistors nur noch um unwesentliche konstruktive Änderungen der Fotomaske, insbesondere der Fenstergestaltung. Eine Fotomaske wird mit Rücksicht auf das Schema der konstruktiven Anordnung von Elementen im Gerät gefertigt (siehe Figuren 5, 6).

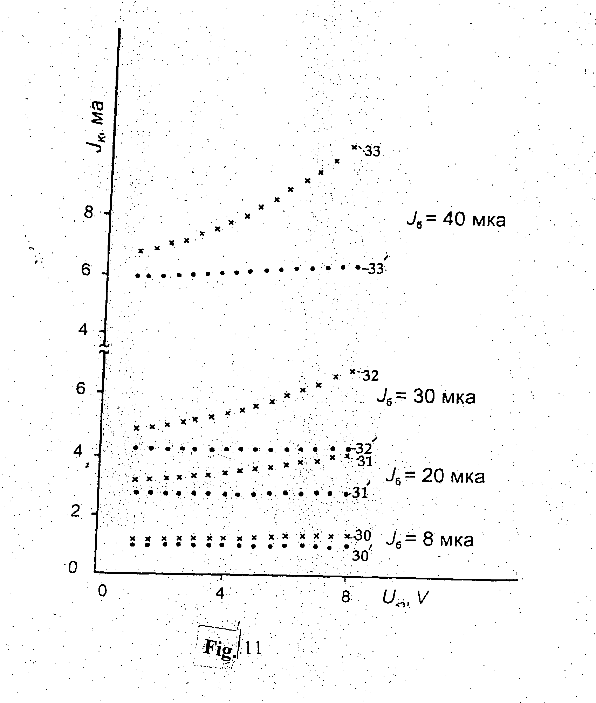

Bei Anwendung des vorerwähnten Verfahrens, also der genormten Halbleitertechnologie, wurde ein Transistor mit geringer Leistung hergestellt. Dabei waren die pn-Übergänge eines Kollektors und eines Emitters entsprechend den Schemata in Figuren 5 und 6 parallel geschaltet. Zur Gegenüberstellung und Kontrolle testete man eine äquivalente Serie von kommerziellen Kontrollmustern aus mehr als 100 Transistoren vom Typ KT 315 G. Fig. 10 zeigt die Messwerte der Ausgangsströme des Kollektors für eine kommerzielle Serie aus 100 Mustern eines Transistors vom Typ KT 315 G (Kurve 28) und aus 100 hergestellten Mustern der erfindungsgemäßen Transistoren (Kurve 29). Die Angaben stellen eine Serie von nachfolgenden Zahlen mit steigender Nummer n dar. Aus diesen Angaben ist zu erkennen, dass die kommerziellen Kontrollmuster eine bedeutende Streuung der Ausgangsstromwerte von 300 bis 600 mA aufweisen, während die erfindungsgemäßen Transistoren stabil sind und keine Wertestreuung haben. Die Erreichung eines technischen Ergebnisses wird weiters durch die Fig. 11 bekräftigt, in welcher statische Eingangs- und Ausgangsstromspannungswerte von erfindungsgemäß gebauten Transistoren veranschaulicht sind.

Fig. 11 (Kurven 30 bis 33) zeigt, dass die kommerziellen Muster nach ihrem Ausgangsstromwert (auf der als Emitter dienenden Basis variierte man den Strom von 0 bis 40 µm, bei einem höheren Strom tritt ein Durchschlag ein) instabil sind und sich die Werte der Ausganstromstärke je nach dem Spannungswert des als Kollektor dienenden Emitters ändern. Aus der selben Fig. 11 (Kurven 30 bis 33) ist erkennbar, dass bei einem erfindungsgemäßen mehrelementigen Transistor der Eingangsstrom stabel ist und bei einer Änderung der Spannung am als Kollektor dienenden Emitter praktisch ein ideales Ergebnis erreichbar ist, weil sämtliche experimentellen Punkte parallel zur Spannungsachse gelegen sind. Dabei erhöht sich der Durchschlagsstrom von 50 mA bis auf 300 mA (siehe Tab. 3), was von einer höheren Beständigkeit gegen die Überlastungen und einem Leistungsanstieg des erfindungsgemäßen Transistors im Vergleich zu einem kommerziellen Transistor zeugt. Wie aus Tabl. 3 ersichtlich ist, in welcher auch Daten zu zulässigen elektrischen Grenzwerten für einen kommerziellen Transistor und einen erfindungsgemäßen Transistor zusammengestellt sind, steigt die Leistung von 77 mW auf 420 mW an. Es sei betont, dass die Stabilität der elektrischen Werte von erfindungsgemäßen Transistoren auch bei einer höheren Umgebungstemperatur von bis 150 0C erhalten bleibt. In zahlenmäßiger Hinsicht erhöht sich die Temperaturbeständigkeit des erwähnten erfindungsgemäßen Transistors um 30 bis 40 Grad. Die Stabilität der elektrischen Werte von erfindungsgemäßen bipolaren Transistoren bleibt auch in einem UHF-Bereich unverändert.

**Tabelle 3**

| Elektrische Werte eines Kontrolltransistors und eines erfindungsgemäßen Transistors. | | | | |
|---|---|---|---|---|
| N, Zahl von pn-Übergängen | PDS, Ibe, µA* | PDS, Ub, V* | PDS, Ib, mA* | Leistung W, mW |
| 1 | 50 | 7 | 11 | 77 |
| 10 | 200 | 7 | 40 | 280 |
| 20 | 300 | 7 | 60 | 420 |

| | | | | |
|---|---|---|---|---|
| * PDS, Ibe : zulässige Stromgrenzwerte des als Basis dienenden Emitters; PDS, Ub : zulässige Spannungsgrenzwerte der Basis; PDS, Ib : zulässige Stromgrenzwerte der Basis. | | | | |

Zu dem Dargelegten soll hinzugefügt werden, dass ähnliche Ergebnisse bei der Herstellung nicht nur von bipolaren Transistoren, sondern auch von Feldtransistoren erhalten worden sind. Allenfalls beobachtet man unabhängig vom Typ des Transistors (sei es ein bipolarer oder Feldtransistor) die Beseitigung einer Streuung und einen Niedergang der Impedanz der pn-Übergänge in Parallelkreisen der Innenstruktur von Halbleitergeräten. Dabei bieten sich verschiedene Vereinigungen und Kombinationen von Transistoren an:
- ein Transistor mit mehreren Emittern (wie z. B. ein ppn-Transistor). Bei diesem Transistor handelt es sich um einen Emitter mit einer Anzahl der pn-Übergänge von N1 > 1, wobei die Einzelbasis einen pn-Übergang und der Einzelkollektor einen pn-Übergang aufweist. Dabei sind die an die p-Gebiete der Emitter anliegenden Elektroden mittels eines Einzelleiters zu einem in einem Punkt konvergierenden Stromkreis parallel geschaltet;
- ein Transistor mit mehreren Kollektoren (ein pnp-Transistor). Bei diesem Transistor geht es um einen Kollektror mit einer Anzahl der pn-Übergänge von über 1, wobei die Basis einen pn-Einzelübergang und der Emitter einen pn-Einzelübergang aufweist. Dabei sind die an die p-Gebiete der Kollektoren anliegenden Elektroden mittels eines Einzelleiters zu einem in einem Punkt konvergierenden Parallelkreis zusammengefasst;
- ein Transistor mit mehreren Basen (ein pnp-Transistor). Bei diesem Transistor handelt es sich um eine Basis mit einer Anzahl der pn-Übergänge von über 1, wobei der Kollektor einen pn-Übergang und der Emitter einen pn-Übergang aufweist. Dabei sind die an die n-Gebiete der Basen anliegenden Elektroden zu einem in einem Punkt konvergierenden Parallelkreis zusammengefasst;
- ein Transistor mit mehreren Basen, Emittern und Kollektoren, (ein pnp-Transistor). Bei diesem Transistor handelt es sich um einen Emitter mit einer Anzahl der p-Gebiete von N1 1 > 1, einen Kollektor mit einer Anzahl der p-Gebiete von N2 > 1 und eine Basis mit einer Anzahl der n-Gebiete von N3 > 1. Dabei sind die an die n-Gebiete der Basen und die p-Gebiete der Emitter und der Kollektoren anliegenden Elektroden innerhalb der betreffenden Mengen der p- oder n-Gebiete zu einem in einem Punkt konvergierenden Parallelkreis zusammengefasst.

Es sind aber auch andere Vereinigungen und Kombinationen vom Typ "Basis/Kollektor/Emitter " (oder Senke/Verschluss/Quelle) denkbar. Alles liegt daran, welchen Effekt der Kunde wünscht : stabile Voltamperecharakteristiken, eine Verstärkung der elektrischen Werte (des Stromes, der Spannung oder generell der Leistung), eine bessere Schnellwirkung des Halbleitergerätes, eine bessere Temperaturbeständigkeit oder einen Anstieg der Grenzfrequenz. Es versteht sich von selbst, dass je größer die Zahl von pn-Übergängen ist, die an die Elektroden von Basis/Emitter/Kollektor in einem Parallelkreis anliegen, desto höher ist die Verstärkung der Leistung.

Je größer die Zahl N1 der pp-Übergänge insbesondere bei einem Transistor mit mehreren Emittern ist, desto mehr sind die Ladungsträger an einem Übergang Emitter/Basis und desto höher ist die Verstärkung des Emitterstromes. Je größer die Zahl N3 der pn-Übergänge bei einem Transistor mit mehreren Kollektoren ist, desto mehr Ladungsträger häufen sich an einer Kollektorelektrode an und desto höher ist die Verstärkung des Stromes im Aussenkreis des Transistors. Bei einem Anstieg der Zahl der pn-Übergänge bei einem Transistor mit mehreren Basen nimmt die Streuung ab und verbessert sich die Stabilität der elektrischen Werte der Basis (Widerstand, Strom, Spannung), so dass sich hochstabilisierte und hochpräzise Voltamperecharakteristiken des Transistors ergeben. Darüber hinaus verbessert sich bei solch einem Transistor dessen Schnellwirkung.

Bei einem Transistor mit mehreren Basen, Emittern und Kollektoren verändern sich alle vorstehend erwähnten Werte :
1. Es wird einer Streuung der elektrischen Werte (Widerstand, Eingangs- und Ausgangsströme, Spannungen) begegnet;
2. Alle Voltamperecharakteristiken des Transistors werden ideal stabil;
3. Alle elektrischen Werte (Strom, Spannung, Leistung) verstärken sich beachtlich;
4. Die Schnellwirkung verbessert sich und die Beständigkeit gegen Temperatur- und Stromüberlastungen erhöht sich.

Bei der Herstellung oder Modifikation von leistungsstarken und sehr leistungsstarken modernen Halbleitergeräten, wie z. B. zusammengesetzten Transistoren, IGBT-Modulen od. dgl., lassen sich entsprechend der zweiten Ausführungsform der anmeldungsgemäßen Erfindung noch bessere Ergebnisse dank einer höheren Verstärkung der elektrischen Werte erzielen. Nachstehend sind in Tab. 4 elektrische Werte für einen leistungsstarken npn-Si-Transistor vom Typ KDT 8281 und für modifizierte und erfindungsgemäß gebaute Transistoren mit acht pn-Übergängen von Basis/Emitter/Kollektor zusammengestellt.

**Tabelle 4**

| Name und Typ d. Transistors | Spannung bei Kollektor/Basis ,V | Spannung bei Kollektor/Emitte r, V | Spannung bei Emitter/ Basis, V | Gleichstrom d. Kollektors, A | Gleichstrom der Basis, A | Kollektorverlustleistung, W |
|---|---|---|---|---|---|---|
| 1. npn-Si-Transistor KTD 8281 | 80 | 80 | 5 | 60 | 5 | 120 |
| 2. Erfindungsgemässer Si-Transistor; d. Zahl d. pn-Übergänge von Basis/Emitter/Kollekto r ist gleich 8 | 300 | 300 | 25 | 400 | 25 | 900 |

Aus der Tabelle 4 ist ersichtlich, dass sämtliche elektrischen Werte des erfindungsgemäßen Transistors mit übergroßer Leistung bedeutend höher liegen als bei dem bekannten Analogon.

Abschließend lässt es sich sagen, dass die vorstehend angeführten Beispiele nur zum besseren Verständnis des Erfindungskernes und der Vorteile der Erfindung angeführt sind dass dadurch keinesfalls alle möglichen Einzelfälle deren Realisierung erschöpft worden sind. Dem Fachmann auf diesem Gebiet leuchtet es ein, dass auch andere konkrete Ausführungsformen zum Einsatz beispielsweise in Thyristoren, Fototransistoren, Leuchtdioden, Halbleiterlasern og. dgl. möglich sind, indem unterschiedliche Vereinigungen (Kombinationen) von p- und n-Gebieten (insbesondere können statt der pnp-Transistoren in ähnlicher Weise auch npn-Transistoren gebaut werden) und andere Halbleiterstoffe, insbesondere Galliumarsenid in Fotovoltaikzellen, polymere Halbleiterstoffe od. dgl. eingesetzt werden können. Es ist offensichtlich, dass alle aufgeführten Ausführungsformen nicht über den Rahmen des Anspruchsumfanges der vorliegenden Erfindung hinausgehen, der ausschließlich durch die beigefügten Patentansprüche definiert wird.

### Gewerbliche Anwendbarkeit

Die vorliegende Erfindung ist bei der Fertigung von hochpräzisen und extrem leistungsfähigen Dioden, Transistoren, Thyristoren, Fotodioden, Leuchtdioden, Halbleiterlasern, Mikroschaltungen und Mikroprozessoren mit stabilen elektrischen Werten, die unter den Bedingungen von herkömmlichen, Hoch- und Ultrahochfrequenzen einsatzfähig sind, anwendbar.

Bei der Fertigung von erfindungsgemäßen Halbleitergeräten braucht man nicht, die bestehende und z. Z. weitgehend verwendete Halbleitertechnologie im Wesentlichen zu ändern. Es sei weiters angemerkt, dass sich irgendwelche grundsätzlich neue Anlagen zur Verwendung von erfindungsgemäß hergestellten Halbleitergeräten ersparen.

## Patentansprüche

1. Halbleitergerät, mit zumindest einem p-Gebiet und zumindest einem n-Gebiet mit an jedes dieser Gebiete anliegenden Elektroden, **dadurch gekennzeichnet, dass** es N > 1 Gebiete mit gleichnamiger Leitfähigkeit (N steht für eine ganze Zahl) und ein Gebiet mit entgegengesetzter Leitfähigkeit unter Bildung von N typengleichen pn-Einzelübergängen aufweist, wobei die an jedes der N Gebiete mit gleichnamigen Leitfähigkeit anliegenden Elektroden mittels eines Einzelleiters parallel geschaltet, d. h. zu einer Einheit zusammengefasst sind.

2. Halbleitergerät nach Anspruch 1, **dadurch gekennzeichnet, dass** die genannten N Gebiete mit gleichnamiger Leitfähigkeit p-Gebiete sind, während das angegebene Einzelgebiet mit entgegengesetzter Leitfähigkeit e in n-Gebiet ist.

3. Halbleitergerät nach Anspruch 2, **dadurch gekennzeichnet, dass** an das angegebene n-Einzelgebiet M Elektroden anliegen, wobei 1 ≤ M ≤ N ist.

4. Halbleitergerät nach Anspruch 3, **dadurch gekennzeichnet, dass** M = 1 ist.

5. Halbleitergerät nach Anspruch 3, **dadurch gekennzeichnet, dass** M > 1 ist und dass die an das n-Gebiet anliegenden Elektroden mittels eines Einzelleiters parallel geschaltet, d. h. zu einer Einheit zusammengefasst sind.

6. Halbleitergerät nach Anspruch 5, **dadurch gekennzeichnet, dass** M = N ist und dass die an das n-Einzelgebiet anliegenden Elektroden im Wesentlichen gegenüber jedem der n-Gebiete angeordnet sind.

7. Halbleitergerät nach Anspruch 1, **dadurch gekennzeichnet, dass** die genannten N Gebiete mit gleichnamiger Leitfähigkeit n-Gebiete sind, während das genannte Einzelgebiet mit entgegengesetzter Leitfähigkeit ein p-Gebiet ist.

8. Halbleitergerät nach Anspruch 7, **dadurch gekennzeichnet, dass** an das angegebene p-Einzelgebiet M Elektroden anliegen, wobei 1 ≤ M ≤ N ist.

9. Halbleitergerät nach Anspruch 8, **dadurch gekennzeichnet, dass** M = 1 ist.

10. Halbleitergerät nach Anspruch 8, **dadurch gekennzeichnet, dass** M > 1 ist und dass die an ein p-Gebiet anliegenden Elektroden mittels eines Einzelleiters parallel geschaltet, d. h. zu einer Einheit zusammengefasst sind.

11. Hälbleitergerät nach Anspruch 10, **dadurch gekennzeichnet, dass** M = N ist und dass die an das p-Einzelgebiet anliegenden Elektroden im Wesentlichen gegenüber jedem der n-Gebiete angeordnet sind.

12. Halbleitergerät nach einem der Ansprüche 1 bis 11, **dadurch gekennzeichnet, dass** N = 4 ist.

13. Halbleitergerät nach einem der Ansprüche 1 bis 11, **dadurch gekennzeichnet, dass** N =8 ist.

14. Halbleitergerät nach einem der Ansprüche 1 bis 11, **dadurch gekennzeichnet, dass** N = 16 ist.

15. Halbleitergerät nach einem der Ansprüche 1 bis 11, **dadurch gekennzeichnet, dass** N ≥ 200 ist.

16. Halbleitergerät mit zumindest einem p-Gebiet und zumindest einem n-Gebiet mit an jedes der genannten Gebiete anliegenden Elektroden, **dadurch gekennzeichnet, dass** es eine erste Menge mit N₁ ≥ 1 Gebieten mit gleichnamiger Leitfähigkeit, eine zweite Menge mit N₂ ≥ 1 Gebieten mit derselben Leitfähigkeit und eine dritte Menge mit N₃ ≥ 1 Gebieten mit entgegengesetzter Leitfähigkeit unter Bildung eines ersten Satzes aus N₁ typengleichen pn-Einzelübergängen und eines zweiten Satzes aus N₃ typengleichen pn-Einzelübergängen aufweist, wobei N₁ + N₂ + N₃ > 3 ist und die Elektroden, die an die Gebiete aus mindestens einer der angegebenen Mengen, für welche die Bedingung N₁ ≥ 2 erfüllt ist, wobei i∈ {1, 2, 3} ist, anliegen, mittels eines Einzelleiters parallel geschaltet, d. h. zu einer Einheit zusammengefasst sind.

17. Halbleitergerät nach Anspruch 16, **dadurch gekennzeichnet, dass** die genannten Gebiete mit gleichnamiger Leitfähigkeit, die Bestandteil der ersten und der zweten Menge bilden, p-Gebiete sind, während die dritte Menge ein oder mehrere n-Gebiete aufweist.

18. Halbleitergerät nach Anspruch 17, **dadurch gekennzeichnet, dass** die erste Menge mehr als ein p-Gebiet enthält, wobei die an jedes der genannten p-Gebiete aus der ersten Menge anliegenden Elektroden mittels eines Einzelleiters parallel geschaltet, d. h. zu einer Einheit zusammengefasst sind.

19. Halbleitergerät nach Anspruch 17 oder 18, **dadurch gekennzeichnet, dass** die zweite Menge mehr als ein p-Gebiet enthält, wobei die an jedes der genannten p-Gebiete aus der zweiten Menge anliegenden Elektroden mittels eines Einzelleiters parallel geschaltet, d. h. zu einer Einheit zusammengefasst sind.

20. Halbleitergerät nach einem der Ansprüche 17 bis 19, **dadurch gekennzeichnet, dass** die dritte Menge mehr als ein n-Gebiet enthält, wobei die an jedes der genannten n-Gebiete aus der dritten Menge anliegenden Elektroden mittels eines Einzelleiters parallel geschaltet, d. h. zu einer Einheit zusammengefasst sind.

21. Halbleitergerät nach Anspruch 17, **dadurch gekennzeichnet, dass** die erste und zweite Menge eine gleiche Anzahl von p-Gebieten aufweist, d. h. dass N₁ = N₂ ist.

22. Halbleitergerät nach Anspruch 17, **dadurch gekennzeichnet, dass** die erste, zweite und dritte Menge jeweils eine gleiche Anzahl von p- und n-Gebieten aufweisen, d. h. dass N₁ = N₂ = N₃ ist.

23. Halbleitergerät nach Anspruch 17, **dadurch gekennzeichnet, dass** die erste und dritte Menge jeweils eine gleiche Anzahl von p- und n-Gebieten aufweisen, d h. dass N₁ = N₃ ist.

24. Halbleitergerät nach Anspruch 17, **dadurch gekennzeichnet, dass** die zweite und dritte Menge jeweils eine gleiche Anzahl von p- und n-Gebieten aufweisen, d. h. dass N₂ = N₃ ist.

25. Halbleitergerät nach Anspruch 16, **dadurch gekennzeichnet, dass** die genannten Gebiete mit gleichnamiger Leitfähigkeit, die Bestandteil der ersten und zweten Menge sind, n-Gebiete sind, während die dritte Menge ein oder mehrere p-Gebiete aufweist.

26. Halbleitergerät nach Anspruch 25, **dadurch gekennzeichnet, dass** die erste Menge mehr als ein n-Gebiet enthält, wobei die an jedes der angegebenen n-Gebiete aus der ersten Menge anliegenden Elektroden mittels eines Einzelleiters parallel geschaltet, d. h. zu einer Einheit zusammengefasst sind.

27. Halbleitergerät nach Anspruch 25 oder 26, **dadurch gekennzeichnet, dass** die zweite Menge mehr als ein n-Gebiet enthält, wobei die an jedes der angegebenen n-Gebiete aus der zweiten Menge anliegenden Elektroden mittels eines Einzelleiters parallel geschaltet, d. h. zu einer Einheit zusammengefasst sind.

28. Halbleitergerät nach einem der Ansprüche 25 bis 27, **dadurch gekennzeichnet, dass** die dritte Menge mehr als ein p-Gebiet enthält, wobei die an jedes der angegebenen p-Gebiete aus der dritten Menge anliegenden Elektroden mittels eines Einzelleiters parallel geschaltet, d. h. zu einer Einheit zusammengefasst sind.

29. Halbleitergerät nach Anspruch 25, **dadurch gekennzeichnet, dass** die erste und zweite Menge eine gleiche Anzahl von n-Gebieten aufweisen, d. h. dass N₁ = N₂ ist.

30. Halbleitergerät nach Anspruch 25, **dadurch gekennzeichnet, dass** die erste, zweite und dritte Menge jeweils eine gleiche Anzahl von n- und p-Gebieten aufweisen, d. h. dass N₁ = N₂ = N₃ ist.

31. Halbleitergerät nach Anspruch 25, **dadurch gekennzeichnet, dass** die erste und dritte Menge jeweils eine gleiche Anzahl von n- und p-Gebieten aufweisen, d. h. dass N₁ = N₃ ist.

32. Halbleitergerät nach Anspruch 25, **dadurch gekennzeichnet, dass** die zweite und dritte Menge jeweils eine gleiche Anzahl von n- und p-Gebieten aufweisen, d. h. dass N₂ = N₃ ist.
